# EUROPÄISCHE PATENTSCHRIFT

(11) **EP 2 482 353 B1**
(45) Veröffentlichungstag und Bekanntmachung des Hinweises auf die Patenterteilung: **02.04.2014**
(21) Anmeldenummer: 11000774.7
(22) Anmeldetag: 01.02.2011
(51) Int. Cl.: H01L 41/047, H01L 41/29, H05K 1/18, H05K 3/32

(54) **Kleberverbindung**
Adhesive connection
Liaison adhésive

(43) Veröffentlichungstag der Anmeldung: 01.08.2012
(73) Patentinhaber: VEGA Grieshaber KG, 77709 Wolfach (DE)
(72) Erfinder: Jacob, Jörn, 77709 Kirnbach (DE); Gruhler, Holger, 78609 Tuningen (DE)
(74) Vertreter: Patentanwälte Westphal, Mussgnug & Partner

(56) Entgegenhaltungen:
- DE-A1- 10 126 655
- DE-A1- 10 126 656
- DE-A1- 10 260 088
- JP-A- 60 054 486
- US-A1- 2010 165 515
- US-B1- 6 472 610

## Beschreibung

Die vorliegende Erfindung betrifft eine Anordnung aus einem Piezoaktor und einer Leiterplatte gemäß Patentanspruch 1 sowie ein Verfahren zur Herstellung einer solchen Anordnung gemäß Patentanspruch 8.

Eine gattungsgemäße Anordnung aus einem Piezoaktor und einer Leiterplatte ist aus dem Stand der Technik bekannt und wird beispielsweise in sogenannten Vibrations-Grenzstandmessgeräten eingesetzt.

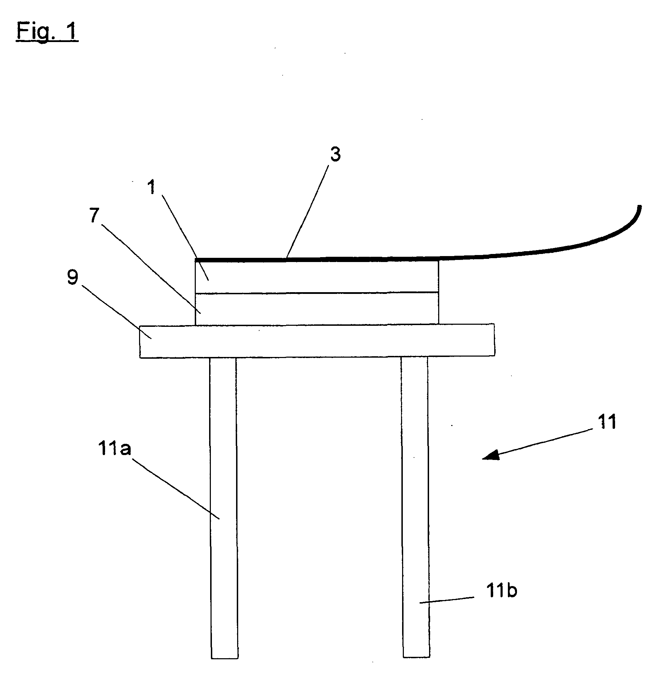

Der schematische Aufbau eines solchen Vibrations-Grenzstandmessgeräts ist in Figur 1 dargestellt.

Der schematische Aufbau in Figur 1 ist weder maßstabsgetreu noch vollständig und soll lediglich nach Art einer PrinzipSkizze die Funktion eines Vibrations-Grenzstandmessgerätes darstellen.

Das dargestellte Vibrations-Grenzstandmessgerät weist als Messfühler eine Schwinggabel 11 auf, die an einer Membran 9 angeordnet ist. Die Membran 9 ist Teil der Schwinggabel 11, wobei Zinken 11a, 11b der Schwinggabel direkt an der Membran 9 angebunden sind und durch Verbiegung der Membran 9 aufeinander zu bzw. voneinander weg bewegt werden.

Die Membran 9 ist in der Regel aus Edelstahl gefertigt und über einen Piezoaktor 1 in Schwingung versetzbar. Der Piezoaktor 1 ist über ein Keramikplättchen 7, das zwischen dem Piezoaktor 1 und der Membran 9 angeordnet ist, mit dieser verbunden. Das Keramikplättchen 7 ist vorgesehen, um die unterschiedlichen thermischen Ausdehnungskoeffizienten der Membran 9 und des Piezoaktors 1 einander anzupassen.

Eine Erregung des Piezoaktors 1 erfolgt über eine elektrische Spannung, die über eine Leiterplatte 3 an der Oberseite des Piezoaktors 1 angelegt wird. Eine Unterseite des Piezoaktors 1 ist durchgehend metallisiert, so dass eine an der Oberseite angelegte Spannung aufgrund einer Segmentierung der Elektrode auf der Oberseite sowie einer unterschiedlichen Polarisation dieser Piezosegmente eine Schwingung des Piezoaktors 1 bewirkt. Die Leiterplatte 3 ist im vorliegenden Beispiel als sogenannte Flexleitung, d. h. als flexibel ausgebildete Leiterplatte mit darauf angeordneten Leiterbahnen, ausgebildet.

Die Flexleitung 3 ist an den zu kontaktierenden Punkten des Piezoaktors 1 mit einem leitfähigen Klebstoff mit diesem verbunden, so dass ausschließlich an den durch den Klebstoff verbundenen Punkten eine Spannung in den Piezoaktor 1 eingeleitet wird. Der Piezoaktor 1 sowie das Keramikplättchen 7 und die Membran 9 sind ebenfalls miteinander verklebt.

Um mit dem Piezoaktor 1 eine Vibration der Schwinggabel 11 zu erzeugen und gleichzeitig eine Frequenzverschiebung oder Dämpfung der Schwinggabel 11 zu detektieren, ist der Piezoaktor 1 in vier Segmente geteilt. Der Piezoaktor 1 ist dabei in der Regel in Draufsicht kreisrund ausgebildet und in vier Quadranten unterteilt, die durch Anlegen einer Spannung jeweils einzeln angesteuert werden können. Zur Erzeugung einer Schwingung werden jeweils zwei diagonal gegenüberliegende Quadranten mit einer Spannung beaufschlagt, während die anderen beiden Quadranten zur Detektion der erzeugten Schwingung benutzt werden. Auf diese Weise kann gleichzeitig eine Schwingung erzeugt und detektiert werden.

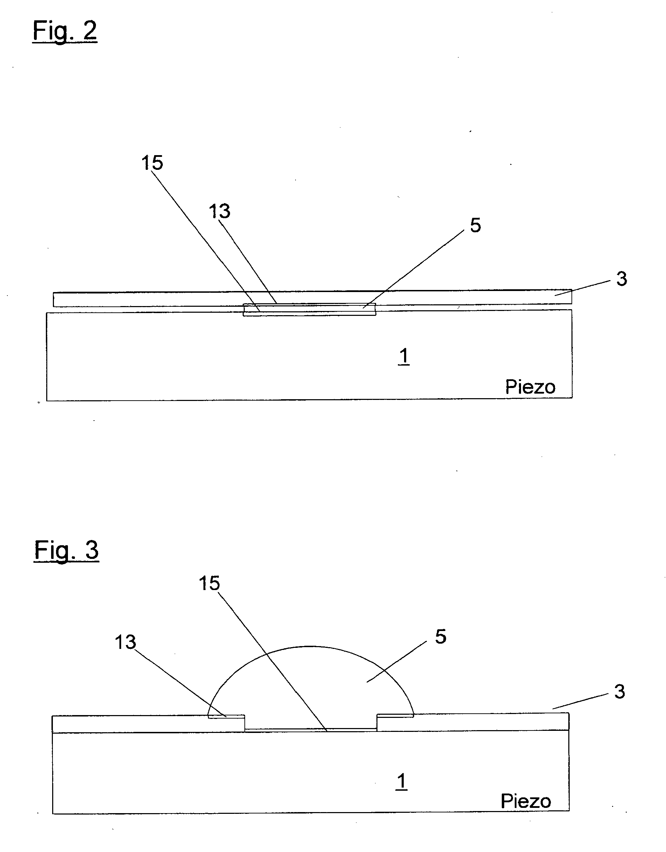

In Figur 2 ist die Anordnung aus Piezoaktor 1 und Leiterplatte 3, wie sie derzeit im Stand der Technik üblich ist, dargestellt. Die Leiterplatte 3 bzw. die Flexleitung weist zum Anlegen der Spannung an den Piezoaktor 1 einen ersten Anschlusskontakt 13 auf. Korrespondierend zu dem ersten Anschlusskontakt 13 ist auf dem Piezoaktor 1 ein zweiter Anschlusskontakt 15 vorgesehen. Um sowohl eine elektrische als auch eine mechanische Verbindung zwischen der Flexleitung 3 und dem Piezoaktor 1 herzustellen, ist es gemäß dem Stand der Technik üblich, zwischen dem ersten Anschlusskontakt 13 und dem zweiten Anschlusskontakt 15 eine elektrisch leitfähige Klebeverbindung 5 herzustellen. Im Stand der Technik ist es derzeit üblich, dazu auf die Anschlusskontakte 15 des Piezoaktors 1 den elektrisch leitfähigen Kleber aufzubringen und anschließend die Flexleitung 3 passend ausgerichtet auf diesem anzuordnen und mit dem Piezzoaktor 1 zu verkleben.

Aufgrund der geringen Klebefläche und des anschließenden Verpressens muss eine Klebstoffmenge sehr klein und sehr genau bemessen sein. Eine exakt reproduzierbare Dosierung einer sehr kleinen Menge eines hochviskosen Mediums ist aufgrund der bei kleinen Volumina dominierenden Oberflächenkräfte nur schwierig zu bewerkstelligen, so dass ein erhöhter Herrstellungsaufwand besteht.

Problematisch bei dieser Vorgehensweise ist es, dass eine im ersten Anlauf falsche Ausrichtung der Flexleitung 3 nicht mehr korrigiert werden kann, da ansonsten der leitfähige Kleber zwischen den Anschlusskontakten 13, 15 verschmiert und als Folge mit Kurzschlüssen zwischen einzelnen Kontakten zu rechnen ist. Es ist darüber hinaus negativ, dass die Flexleitung 3 und der Piezoaktor 1 aufgrund der dazwischen befindlichen Klebeverbindung 5 nicht unmittelbar aufeinander angeordnet werden können. Negativ ist außerdem, dass durch ein Verpressen von Flexleitung 3 und Piezoaktor 1 die dazwischen befindliche Klebeverbindung 5 flachgedrückt und damit gegebenenfalls überschüssiger Klebstoff seitlich neben den Anschlusskontakten 13, 15 herausgedrückt wird. Dies erhöht die Gefahr von Kurzschlüssen.

Aufgrund der rein stoffschlüssigen Verbindung zwischen Flexleitung 3 und Piezoaktor 1 muss jegliche spätere Belastung der Klebeverbindung 5 durch Kohäsions- und Adhäsionskräfte aufgenommen werden.

Nach dem Aufbringen des Klebers muss die Flexleitung planparallel und exakt zum Piezoaktor 1 positioniert werden. Aus den oben dargestellten Gründen ist eine nachträgliche Positionskorrektur nicht möglich.

Die US 2010/165515 A1 offenbart eine Anordnung aus einem Piezoaktor und einer Leiterplatte mit wenigstens einer durch einen elektrisch leitfähigen Klebstoff hergestellten elektrischen Verbindung zwischen einem ersten flächigen Anschlusskontakt an der Leiterplatte und einem zweiten flächigen Anschlusskontakt an dem Piezoaktor, wobei die Kontaktflächen der Anschlusskontakte in die gleiche Richtung weisen und die Klebeverbindung durch eine Öffnung in der Leiterplatte erfolgt. Zwischen der Leiterplatte und dem Piezoaktor ist ein Flüssigkeitsstopper angeordnet, der den Abstand zwischen Aktor und Leiterplatte verringert, um einen kontrollierten Kapillareffekt für den Klebstoff zu erzeugen.

Es ist die Aufgabe der vorliegenden Erfindung, die oben beschriebenen Nachteile zu beheben und die Prozessführung bei der Herstellung der beschriebenen Anordnung zu vereinfachen.

Diese Aufgaben werden gelöst durch eine Anordnung mit den Merkmalen des Patentanspruchs 1 sowie ein Verfahren mit den Merkmalen des Patentanspruchs 8.

Durch die erfindungsgemäße Anordnung aus einem Piezoaktor und einer Leiterplatte wird eine formschlüssige nietenartige Klebeverbindung erreicht, die sehr belastbar ist. Dadurch, dass der Piezoaktor und die Leiterplatte vor der Klebung exakt zueinander ausgerichtet werden können, ist es nicht notwendig, nach dem Aufbringen des Klebers eine Positionskorrektur durchzuführen. Da auf diese Weise ein Verschmieren von Klebstoff vermieden werden kann, werden Kurzschlüsse zwischen einzelnen Anschlusskontakten weitgehend vermieden. Darüber hinaus kann eine verwendete Klebstoffmenge für die Klebeverbindung erhöht werden und muss außerdem weniger präzise dosiert sein.

Eine besonders günstige Ordnung ergibt sich, wenn die Leiterplatte auf dem Piezoaktor angeordnet ist. Darüber hinaus ist es vorteilhaft, wenn die Leiterplatte als flexible Leiterplatte ausgebildet ist.

Durch eine flexible Leiterplatte, einen sogenannten Flexleiter, wird erreicht, dass der Piezoaktor einerseits flächig mit der Leiterplatte verklebt werden kann und andererseits dennoch eine flexible Signal Zu- und Ableitung ermöglicht wird.

Eine günstige Möglichkeit zur Herstellung elektrischer Kontakte besteht, wenn der erste Anschlusskontakt ringförmig ausgebildet ist. Besonders günstig ist die Anordnung, wenn der zweite Anschlusskontakt kreisförmig ausgebildet ist.

Wenn die Öffnung für die Klebung im Inneren des ringförmig ausgebildeten Anschlusskontaktes angeordnet ist, kann dadurch erreicht werden, dass zusätzlich zu einer mechanisch sehr belastbaren Verbindung außerdem eine gute elektrische Verbindung zwischen dem ersten Anschlusskontakt auf der Flexleitung und dem zweiten Anschlusskontakt auf dem Piezoaktor hergestellt wird.

Eine mechanisch besonders vorteilhafte Ausgestaltung wird dadurch erreicht, dass der Piezoaktor und die Leiterplatte unmittelbar aufeinander angeordnet sind.

Auf diese Weise wird eine flächige Anordnung von Flexleitung und Piezoaktor erreicht, wobei zwischen den beiden Komponenten kein Luftspalt verbleibt. Eine solche Anordnung ist vorteilhaft, da bei direkt aufeinander angeordneten Komponenten keine Hebelkräfte an den Kanten der Klebung zu erwarten sind, so dass die so geschaffene Verbindung mechanisch hochstabil ist.

Eine besonders stabile Ausgestaltung der Klebeverbindung wird erreicht, wenn der Klebstoff die Anschlussflächen kuppelartig abdeckt.

Diese Art der Klebeverbindung ist vorteilhaft, da so eine kreisförmige Fläche auf dem Piezoaktor und eine ringförmige Fläche auf der Flexleitung geschaffen werden, die jeweils von dem Klebstoff abgedeckt sind.

Für die vorliegende Anwendung ist es besonders vorteilhaft, wenn der Piezoaktor vierfach segmentiert und jeweils eine Klebeverbindung vorgesehen ist.

Durch einen kreisförmig ausgebildeten und vierfach segmentierten Piezoaktor, von dem jedes Segment einzeln ansteuerbar ist, wird erreicht, dass gleichzeitig durch Ansteuerung zweier diagonal gegenüberliegender Segmente des Piezoaktors eine Schwingung erzeugt und gleichzeitig mit den übrigen beiden Segmenten detektiert werden kann. Es ist aber auch denkbar, eine erfindungsgemäße Klebeverbindung auch in anderen Einsatzgebieten, bei denen eine Flexleitung auf einem darunter befindlichen Element angeordnet werden soll, einzusetzen.

Bei dem erfindungsgemäßen Verfahren zur Herstellung einer leitenden Klebeverbindung zwischen einer Leiterplatte mit einem ersten Anschlusskontakt und einem Piezoaktor mit einem zweiten Anschlusskontakt, wobei die Leiterplatte eine Öffnung im Bereich des Anschlusskontaktes aufweist, werden in einem ersten Schritt die Leiterplatte und der Piezoaktor unmittelbar aufeinander und ausgerichtet zueinander angeordnet und aneinander gepresst, in einem zweiten Schritt eine geeignete Menge leitenden Klebstoffs auf die Anschlusskontakte derart aufgebracht, dass eine Verbindung zwischen diesen hergestellt wird und in einem dritten Schritt die Klebeverbindung ausgehärtet.

Gegenüber dem Stand der Technik weist das erfindungsgemäße Verfahren den Vorteil auf, dass die Leiterplatte und der Piezoaktor vor dem Aufbringen des Klebstoffs zueinander ausgerichtet werden können und so ein nachträgliches Korrigieren einer möglicherweise fehlerhaften Ausrichtung vermieden werden kann. Das Verfahren hat außerdem den Vorteil, dass es nicht notwendig ist, die einzelnen Klebekomponenten mit dazwischen angeordnetem Klebstoff zu verpressen, so dass vermieden wird, dass Klebstoff über die eigentlich zu klebende Fläche hinaus verteilt wird. Auf diese Weise werden Kurzschlüsse durch den leitenden Klebstoff, der beim Verpressen gegebenenfalls herausquillt, vermieden. Ein weiterer Vorteil des erfindungsgemäßen Verfahrens ist außerdem, dass die für die Verklebung verwendete Menge des leitenden Klebstoffs größer dimensioniert und weniger genau abgemessen sein kann. Auf diese Weise wird das Montageverfahren erheblich vereinfacht.

Es ist für die Qualität der erreichten Klebeverbindung günstig, dass die Leiterplatte und der Piezoaktor vor dem Aufbringen des Klebstoffs aufeinandergepresst werden.

Auf diese Weise wird vermieden, dass beim Aufbringen des Klebstoffs dieser den Zwischenraum zwischen Piezoaktor und Leiterplatte kapillar unterwandert und so gegebenenfalls doch Kurzschlüsse entstehen.

Günstigerweise wird soviel Klebstoff aufgebracht, dass der Klebstoff die Anschlusskontakte kuppelartig überspannt. Es wird auf diese Weise eine besonders stabile Klebeverbindung erreicht, die außerdem sehr einfach herzustellen ist.

Um eine besonders günstige elektrische Verbindung zwischen den Anschlusskontakten herzustellen, ist es vorteilhaft, wenn der erste Anschlusskontakt ringförmig um die Öffnung ausgebildet wird und/oder der zweite Anschlusskontakt kreisförmig ausgebildet wird. Auf diese Weise wird erreicht, dass eine leitende Klebeverbindung in jede Richtung einen elektrischen Kontakt herstellt und so eine zuverlässige und verlustarme Einkopplung der Spannung auf den Piezoaktor ermöglicht wird.

Die Erfindung wird nachfolgend unter Bezugnahme auf die beigefügten Figuren eingehend erläutert.

Es zeigen:
- Fig. 1: einen schematischen Aufbau eines Vibrations-Grenzstandmessgerätes (schon behandelt),
- Fig. 2: eine leitende Klebeverbindung gemäß dem Stand der Technik (schon behandelt) und
- Figur 3: eine erfindungsgemäße Klebeverbindung.

Figur 3 zeigt eine erfindungsgemäße Klebeverbindung 5 zwischen einem Piezoaktor 1 und einer Leiterplatte 3. Die Leiterplatte 3 ist im vorliegenden Beispiel als sogenannte Flexleitung, d. h. als flexibel ausgebildete Leiterplatte mit darauf angeordneten Leiterbahnen, ausgebildet. Die Flexleitung 3 ist unmittelbar auf dem Piezoaktor 1 angeordnet und weist einen ringförmigen, auf der von dem Piezoaktor 1 wegweisenden Seite der Flexleitung 3 angeordneten ersten Anschlusskontakt 13 auf.

Im Inneren des ersten Anschlusskontaktes 13 weist die Flexleitung 3 eine Öffnung auf, innerhalb derer ein zweiter Anschlusskontakt 15, der auf dem Piezoaktor 1 angeordnet ist, positioniert ist. Der Piezoaktor 1 und die Flexleitung 3 sind über eine Klebeverbindung 5 miteinander verbunden. Die Klebeverbindung 5 ist aus einem elektrisch leitfähigen Klebstoff derart hergestellt, dass sie die Anschlusskontakte 13, 15 abdeckt und damit eine im Querschnitt nietenartig ausgebildete Klebeverbindung 5 bildet.

Die auf diese Weise gebildete Anordnung aus Piezoaktor 1 und Flexleitung 3 wird bevorzugt in Vibrations-Grenzstandmessgeräten, wie sie aus dem Stand der Technik bekannt sind, eingesetzt.

Die Anschlusskontakte 13, 15 auf der Flexleitung 3 und dem Piezoaktor 1 können beispielsweise durch eine aufgebrachte Goldschicht gebildet sein. Der für die Klebeverbindung 5 verwendete Klebstoff kann bspw. mit Silberpartikeln versetzt sein, so dass eine elektrische Leitfähigkeit gewährleistet ist.

### Bezugszeichenliste

- 1: Piezoaktor
- 3: Leiterplatte/ Flexleitung
- 5: Klebeverbindung
- 7: Keramikplättchen
- 9: Membran
- 11: Schwinggabel
- 11a,b: Zinken
- 13: erster Anschlusskontakt
- 15: zweiter Anschlusskontakt

## Patentansprüche

1. Anordnung aus einem Piezoaktor (1) und einer Leiterplatte (3), die durch wenigstens eine Klebeverbindung (5) verbunden sind, mit wenigstens einer durch einen elektrisch leitfähigen Klebstoff hergestellten elektrischen Verbindung zwischen einem ersten flächigen Anschlusskontakt (13) an der Leiterplatte (3) und einem zweiten flächigen Anschlusskontakt (15) an dem Piezoaktor (1), wobei die Kontaktflächen der Anschlusskontakte (13, 15) in die gleiche Richtung weisen und die Klebeverbindung (5) durch eine Öffnung in der Leiterplatte (3) erfolgt, **dadurch gekennzeichnet, dass** der Piezoaktor (1) und die Leiterplatte (3) unmittelbar aufeinander angeordnet sind, wobei zwischen dem Piezoaktor (1) und der Leiterplatte (3) kein Luftspalt verbleibt.

2. Anordnung nach Anspruch 1,
**dadurch gekennzeichnet, dass** die Leiterplatte (3) auf dem Piezoaktor (1) angeordnet ist.

3. Anordnung nach einem der vorhergehenden Ansprüche,
**dadurch gekennzeichnet, dass** die Leiterplatte (3) als flexible Leiterplatte ausgebildet ist.

4. Anordung nach einem der vorhergehenden Ansprüche,
**dadurch gekennzeichnet, dass** der erste Anschlusskontakt (13) ringförmig ausgebildet ist.

5. Anordung nach einem der vorhergehenden Ansprüche,
**dadurch gekennzeichnet, dass** der zweite Anschlusskontakt (15) kreisförmig ausgebildet ist.

6. Anordnung nach einem der vorhergehenden Ansprüche,
**dadurch gekennzeichnet, dass** der Klebstoff die Anschlusskontakte (13, 15) kuppelartig abdeckt.

7. Anordnung nach einem der vorhergehenden Ansprüche,
**dadurch gekennzeichnet, dass** der Piezoaktor (1) vierfach segmentiert ist und jeweils eine Klebeverbindung (5) vorgesehen ist.

8. Verfahren zur Herstellung einer leitenden Klebeverbindung (5) zwischen einer Leiterplatte (3) mit einem ersten flächigen Anschlusskontakt (13) und einem Piezoaktor (1) mit einem zweiten flächigen Anschlusskontakt (15), wobei die Kontaktflächen der Anschlusskontakte (13, 15) in die gleiche Richtung weisen und wobei die Leiterplatte (3) eine Öffnung im Bereich des ersten Anschlusskontakts (13) aufweist, mit den Schritten:
- ausgerichtetes Anordnen von Leiterplatte (3) und Piezoaktor (1) zueinander und unmittelbar aufeinander, wobei zwischen dem Piezoaktor (1) und der Leiterplatte (3) kein Luftspalt verbleibt,
- Aneinanderpressen von Leiterplatte (3) und Piezoaktor (1) vor dem Aufbringen eines Klebstoffes,
- Aufbringen einer geeigneten Menge leitenden Klebstoffs auf die Anschlusskontakte (13, 15) derart, dass eine Verbindung zwischen diesen hergestellt wird, und
- Aushärten des Klebstoffes.

9. Verfahren nach Anspruch 8,
**dadurch gekennzeichnet, dass** soviel Klebstoff aufgebracht wird, dass der Klebstoff die Anschlusskontakte (13, 15) kuppelartig überspannt.

10. Verfahren nach einem der Ansprüche 8 - 9,
**dadurch gekennzeichnet, dass** der erste Anschlusskontakt (13) ringförmig ausgebildet wird.

11. Verfahren nach einem der Ansprüche 8 - 10,
**dadurch gekennzeichnet, dass** die Öffnung im Inneren des ringförmigen ersten Anschlusskontaktes (13) angeordnet wird.

## Claims

1. Arrangement comprising a piezoelectric actuator (1) and a printed circuit board (3) which are connected by at least one adhesive connection (5), having at least one electrical connection established by an electrically conductive adhesive between a first planar terminal contact (13) on the printed circuit board (3) and a second planar terminal contact (15) on the piezoelectric actuator (1), wherein the contact surfaces of the terminal contacts (13, 15) point in the same direction and the adhesive connection (5) is effected through an opening in the printed circuit board (3),
**characterised in that**
the piezoelectric actuator (1) and the printed circuit board (3) are arranged directly on one another, no air gap remaining between the piezoelectric actuator (1) and the printed circuit board (3).

2. Arrangement according to claim 1
**characterised in that**
the printed circuit board (3) is arranged on the piezoelectric actuator (1).

3. Arrangement according to one of the preceding claims,
**characterised in that**
the printed circuit board (3) is constructed as a flexible printed circuit board.

4. Arrangement according to one of the preceding claims
**characterised in that**
the first terminal contact (13) is constructed in an annular manner.

5. Arrangement according to one of the preceding claims,
**characterised in that**
the second terminal contact (15) is constructed in a circular manner.

6. Arrangement according to one of the preceding claims,
**characterised in that**
the adhesive covers the terminal contacts (13, 15) in a dome-like manner.

7. Arrangement according to one of the preceding claims,
**characterised in that**
the piezoelectric actuator (1) is segmented four-fold and an adhesive connection (5) is provided for each segment.

8. Process for the production of a conductive adhesive connection (5) between a printed circuit board (3) having a first planar terminal contact (13) and a piezoelectric actuator (1) having a second planar terminal contact (15), wherein the contact areas of the terminal contacts (13, 15) point in the same direction and wherein the printed circuit board (3) has an opening in the region of the first terminal contact (13), having the steps:
- aligned arrangement of the printed circuit board (3) and piezoelectric actuator (1) relative to one another and directly on one another, no air gap remaining between the piezoelectric actuator (1) and the printed circuit board (3),
- pressing of the printed circuit board (3) and piezoelectric actuator (1) on one another before application of an adhesive,
- application of a suitable amount of conductive adhesive to the terminal contacts (13, 15) such that a connection is established between these, and
- curing of the adhesive.

9. Process according to claim 8,
**characterised in that**
enough adhesive is applied for the adhesive to span the terminal contacts (13, 15) in a dome-like manner.

10. Process according to one of claims 8 - 9,
**characterised in that**
the first terminal contact (13) is constructed in an annular manner.

11. Process according to one of claims 8 - 10,
**characterised in that**
the opening is arranged inside the annular first terminal contact (13).

## Revendications

1. Dispositif constitué par un actionneur piézoélectrique (1) et par une plaquette de circuits imprimés (3) qui sont reliés par au moins une liaison adhésive (5), comportant au moins une liaison électrique obtenue par au moins un adhésif électriquement conducteur entre un premier contact de liaison-plan (13) situé sur la plaquette de circuits imprimés (3) et un second contact de liaison-plan (15) situé sur l'actionneur piézoélectrique (1), dans lequel les surfaces de contact des contacts de liaison (13, 15) sont orientées dans la même direction, et la liaison adhésive (5) est effectuée au travers d'une ouverture réalisée dans la plaquette de circuits imprimés (3),
**caractérisé en ce que**
l'actionneur piézoélectrique (1) et la plaquette de circuits imprimés (3) sont montés directement l'un sur l'autre, aucun interstice d'air n'étant maintenu entre l'actionneur piézoélectrique et la plaquette de circuits imprimés (3).

2. Dispositif conforme à la revendication 1,
**caractérisé en ce que**
la plaquette de circuits imprimés (3) est montée sur l'actionneur piézoélectrique (1).

3. Dispositif conforme à l'une des revendications précédentes,
**caractérisé en ce que**
la plaquette de circuits imprimés (3) est réalisée sous la forme d'une plaquette de circuits imprimés flexible.

4. Dispositif conforme à l'une des revendications précédentes,
**caractérisé en ce que**
le premier contact de liaison (13) est un contact de liaison annulaire.

5. Dispositif conforme à l'une des revendications précédentes,
**caractérisé en ce que**
le second contact de liaison (15) est un contact de liaison circulaire.

6. Dispositif conforme à l'une des revendications précédentes,
**caractérisé en ce que**
l'adhésif recouvre les contacts de liaison (13, 15) à la manière d'une coupelle.

7. Dispositif conforme à l'une des revendications précédentes,
**caractérisé en ce que**
l'actionneur piézoélectrique (1) est subdivisé en plusieurs segments respectivement équipés d'une liaison adhésive (5).

8. Procédé d'obtention d'une liaison adhésive conductrice (5) entre une plaquette de circuits imprimés (3) ayant un premier contact de liaison-plan (13) et un actionneur piézoélectrique (1) ayant un second contact de liaison-plan (15), les surfaces de contact des contacts de liaison (13, 15) étant orientées dans la même direction et la plaque de circuits imprimés (3) comportant une ouverture dans la zone du premier contact de liaison (13), comportant les étapes consistant à :
- positionner en les orientant l'un par rapport à l'autre la plaquette de circuits imprimés (3) et l'actionneur piézoélectrique (1) directement l'un sur l'autre, aucun interstice d'air ne subsistant entre l'actionneur piézoélectrique (1) et la plaquette de circuits imprimés (3),
- comprimer l'un contre l'autre la plaquette de circuits imprimés (3) et l'actionneur piézoélectrique (1) avant l'application d'un adhésif,
- appliquer une quantité adaptée d'adhésif conducteur sur les contacts de liaison (13, 15) de façon à obtenir une liaison entre ces contacts et
- durcir l'adhésif.

9. Procédé conforme à la revendication 8,
**caractérisé en ce que**
l'on applique suffisamment d'adhésif pour que cet adhésif recouvre les contacts de liaison (13, 15) à la manière d'une coupelle.

10. Procédé conforme à l'une des revendications 8 et 9,
**caractérisé en ce que**
le premier contact de liaison (13) est un contact de liaison annulaire.

11. Procédé conforme à l'une des revendications 8 et 10,
**caractérisé en ce que**
l'ouverture est située à l'intérieur du premier contact de liaison annulaire (13).
